# EUROPÄISCHE PATENTSCHRIFT

(11) **EP 3 169 500 B1**
(45) Veröffentlichungstag und Bekanntmachung des Hinweises auf die Patenterteilung: **21.03.2018**
(21) Anmeldenummer: 15756810.6
(22) Anmeldetag: 24.06.2015
(51) Int. Cl.: B29C 35/04, B29C 35/06, B29C 41/28, B29C 41/46

(54) **VORRICHTUNG MIT ZUMINDEST EINEM ENDLOSBAND**
DEVICE COMPRISING AT LEAST ONE ENDLESS BELT
UN DISPOSITIF AVEC AU MOINS UNE BANDE SANS FIN

(30) Priorität: 26.06.2014 AT 504432014
(43) Veröffentlichungstag der Anmeldung: 24.05.2017
(73) Patentinhaber: Berndorf Band GmbH, 2560 Berndorf (AT)
(72) Erfinder: PROSCHEK, Michael, A-2525 Schönau (AT); WILLIMAYER, Gerhard, A-2563 Pottenstein (AT)
(74) Vertreter: Burger, Hannes
(86) Internationale Anmeldenummer: PCT/AT2015/050158
(87) Internationale Veröffentlichungsnummer: WO 2015/196227

(56) Entgegenhaltungen:
- EP-A1- 2 559 537
- WO-A1-2006/101220
- WO-A1-2009/038060
- DE-A1- 2 345 205
- DE-T2- 69 027 238
- JP-A- 2012 196 858
- US-A1- 2009 134 553
- US-A1- 2014 058 060

## Beschreibung

Die Erfindung betrifft eine Vorrichtung gemäß dem Oberbegriff von Anspruch 1.

Vorrichtungen der eingangs genannten Art kommen beispielsweise bei der Herstellung von Filmen, insbesondere Triacetatfilmen, welche insbesondere für die Produktion von LCD-Bildschirmen verwendet werden, zum Einsatz. Hierbei läuft ein als Prozessband für das Auftragen und den Transport des Films dienendes Endlosband zwischen einer Antriebsrolle und einer Umlenkrolle um, zwischen welchen das Band eingespannt ist. Vorrichtungen der soeben genannten Art sind aus der DE2345205A1 sowie der JP2012196858A bekannt geworden.

Bei Vorrichtungen der oben genannten Art wird das Endlosband von der Umlenkrolle um näherungsweise 180° umgelenkt. Obertrum und Untertrum verlaufen dabei im Wesentlichen parallel zueinander. Das Obertrum bildet im Stand der Technik häufig eine Auflagefläche und/oder Transportfläche für ein Medium, welches beispielsweise in flüssiger Form auf das sich bewegende und zwischen der Antriebsrolle und der Umlenkrolle umlaufende Endlosband, welches aus Metall gefertigt sein kann, aufgebracht wird.

Zumindest das Obertrum des Endlosbandes wird üblicherweise durch einen Trocknungstunnel geführt, in welchem der Film getrocknet wird. Üblicherweise sind in dem Trocknungstunnel auf Seiten einer Oberfläche d.h. einer Außenfläche des Endlosbandes, auf welcher der Film aufgetragen ist, Heizelemente angeordnet. Die Unterseite d.h. die Innenseite des Endlosbandes wird hingegen mittels eines heißen gasförmigen Mediums, insbesondere mittels erhitzter Luft erwärmt. Das erhitzte gasförmige Medium strömt üblicherweise aus Düsenkästen gegen die Unterseite des Endlosbandes und wird von einer Unterseite des Endlosbandes abgelenkt. Die so entstandene Prallströmung wird mittels zwischen den Düsenkästen angeordneten Absaugöffnungen abgesaugt. Die bekannten Düsenkästen weisen mehrere Ausströmöffnungen bzw. Ausströmschlitze auf, die in Längsrichtung des Endlosbandes betrachtet hintereinander angeordnet sind, wobei zwischen den Ausströmöffnungen eines Düsenkastens keine Absaugöffnungen angeordnet sind. Dies hat zur Folge, dass das Volumen des von zwei Absaugöffnungen und der Unterseite des Endlosbandes begrenzten Raumes sehr klein ist, während hingegen der Raum zwischen zwei Düsenkästen ein vergleichsweise großes Volumen aufweist, wodurch es bei der Absaugung des gasförmigen Mediums bei den bekannten Lösungen zu sehr hohen Strömungsgunterschieden und Verwirbelungen auf der Unterseite des Endlosbandes kommen kann, was zu unerwünschten Temperaturunterschieden in dem Endlosband führen kann. So ist es ein häufig auftretendes Problem, bei bekannten Vorrichtungen zum Filmgießen, dass sich das Endlosband an seinen Rändern stärker erhitzt als in zentraler gelegenen Bereichen.

Auch ist bei den bekannten Lösungen eine sehr hohe Absaugleistung erforderlich, um die gesamte Luft aus den sehr eng beieinander liegenden Ausströmöffnungen eines Düsenkastens absaugen zu können. Aufgrund der hohen Absaugleistung kann es bei den bekannten Vorrichtungen, vor allem in einem Anfangsbereich des Trocknungstunnels, dazu kommen, dass von den auf der Unterseite des Endlosbandes angeordneten Absaugöffnungen Luft von der Oberseite des Endlosbandes mitabgesaugt wird. Dies hat jedoch neben einer starken Verwirbelung der Strömung auch den nachteiligen Effekt, dass die Temperatur auf der Oberseite des Endlosbandes sich in Undefinierter Weise verändern und es zu einer starken Beeinträchtigung des hergestellten Produktes kommen kann.

Es ist daher eine Aufgabe der Erfindung, die oben genannten Nachteile des Stands der Technik zu überwinden.

Diese Aufgabe wird mit einer Vorrichtung der eingangs genannten Art erfindungsgemäß durch die Merkmale des kennzeichnenden Teils von Anspruch 1 gelöst.

Die erfindungsgemäße Lösung ermöglicht ein wesentlich verbessertes Absaugen des gasförmigen Mediums an der Unterseite des Endlosbandes was eine sehr starke Beruhigung des Gasstromes zur Folge hat. Aufgrund der verbesserten Rückführung des gasförmigen Mediums an der Unterseite können auch Druckunterschiede zwischen der Unterseite und der Oberseite des Endlosbandes sehr stark minimiert bzw. sogar ganz verhindert werden, sodass auch eine Durchmischung von Luft über und unter dem Endlosband während des Trocknungsprozesses sehr gut unterbunden werden kann. Weiters wird eine möglichst gleichmäßige Strömung erzielt, dadurch, dass die Absaugöffnungen mit einem Filter abgedeckt sind. Als besonders vorteilhaft hat es sich hierbei erwiesen, wenn der Filter als Lochblech ausgeführt ist.

Gemäß einer Variante der Erfindung, welche bei einer sehr guten Ausnutzung des zur Verfügung stehenden Bauraums eine möglichst große Fläche der Absaugöffnung und somit ein optimales Strömungsprofil unterhalb des Endlosbandcs ermöglicht, kann es vorgesehen sein, dass eine in Längsrichtung des Endlosbandes verlaufende Breite der Absaugöffnungen im Wesentlichen dem Abstand zwischen zwei benachbarten Düsenkästen entspricht.

Um eine möglichst gleichmäßiges Ausströmverhalten des gasförmigen Mediums aus allen Düsenkästen zu erzielen kann es vorgesehen sein, dass die Zuleitung durch einen Kanal gebildet wird, von welchem die inneren Hohlräume aller Düsenkästen abzweigen. Die Strömungsverhältnisse entlang der Breite des Endlosbandes lassen sich dadurch weiter optimieren, dass die Ausströmöffnungen in einer Querrichtung des Endlosbandes betrachtet im Wesentlichen über die gesamte Breite der Düsenkästen verlaufen.

Um auch eine gleichmäßige Absaugung des an der Unterseite des Endlosbandes reflektierten gasförmigen Mediums zu erzielen, kann die Ableitung einen Kanal aufweisen, in welchen rohrförmige Leitungen münden, die an einem dem Endlosband zugewandten Ende jeweils offen ausgebildet sind, wobei die Absaugöffnungen jeweils durch diese offenen Enden gebildet sind.

Gemäß einer Weiterbildung der Erfindung, welche sich durch eine besonders hohe Energieeffizienz auszeichnet, kann es vorgesehen sein, dass ein Ausströmbereich der Ableitung mit einem Einströmbereich der Zuleitung über eine Umlenkvorrichtung zur Umkehrung einer Strömungsrichtung des gasförmigen Mediums verbunden ist. Gemäß dieser Ausfuhrungsform der Erfindung wird das gasförmige Medium in einem geschlossenen Kreislauf verwendet.

Nach einer Variante der Erfindung kann es weiters vorgesehen sein, dass die Umlenkvorrichtung einen Kanal umfasst, der die Ableitung mit der Zuleitung verbindet, wobei in dem Kanal zumindest ein Heizelement, insbesondere ein Gasbrenner, angeordnet ist, wobei in einer Strömungsrichtung des gasförmigen Mediums betrachtet, vor dem Heizelement zumindest eine Abschirmung angeordnet ist, durch welche das gasförmige Medium seitlich an dem Heizelement vorbeigeleitet ist. Durch die Anordnung des Heizelementes kann das gasförmige Medium, bevor es wieder auf eine Oberfläche des Endlosbandes auftrifft, auf eine gewünschte Temperatur erhitzt werden. Durch den Schild kann das Heizelement zusätzlich gegen Einflüsse der Strömung abgeschirmt werden. So kann, wenn beispielsweise ein Gasbrenner verwendet wird, ein Auslöschen der Flamme durch das strömende Medium sehr effizient verhindert werden. An dieser Stelle sei jedoch erwähnt, dass anstelle eines Gasbrenners auch ein Heizelement anderer Bauart, beispielsweise ein elektrisches Heizelement verwendet werden kann.

Um auf einfache Weise eine Strömung in dem gasförmigen Medium zu erzeugen, kann in dem Kanal eine Vorrichtung zur Erzeugung einer Strömung, insbesondere ein Gebläse, angeordnet sein.

Zum besseren Verständnis der Erfindung wird diese anhand der nachfolgenden Figuren näher erläutert.

Es zeigen jeweils in stark vereinfachter, schematischer Darstellung:
- Fig. 1: Einen Schnitt durch einen Teil einer erfindungsgemäße Vorrichtung;
- Fig. 2: Die Vorrichtung aus Fig. 1 mit einer Zu- und Ableitung für ein gasförmiges Medium;
- Fig. 3: Eine Draufsicht auf Düsenkästen der Vorrichtung aus Fig. 1 und 2;
- Fig. 4: Einen Schnitt durch eine erfindungsgemäße Vorrichtung mit einer Umlenkvorrichtung für das gasförmige Medium.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind diese Lageangaben bei einer Lageänderung sinngemäß auf die neue Lage zu übertragen. Weiters können auch Einzelmerkmale oder Merkmalskombinationen aus den gezeigten und beschriebenen unterschiedlichen Ausführungsbeispielen für sich eigenständige, erfinderische oder erfindungsgemäße Lösungen darstellen.

Sämtliche Angaben zu Wertebereichen in gegenständlicher Beschreibung sind so zu verstehen, dass diese beliebige und alle Teilbereiche daraus mitumfassen, z.B. ist die Angabe 1 bis 10 so zu verstehen, dass sämtliche Teilbereiche, ausgehend von der unteren Grenze 1 und der oberen Grenze 10 mit umfasst sind, d.h. sämtliche Teilbereiche beginnen mit einer unteren Grenze von 1 oder größer und enden bei einer oberen Grenze von 10 oder weniger, z.B. 1 bis 1,7, oder 3,2 bis 8,1, oder 5,5 bis 10.

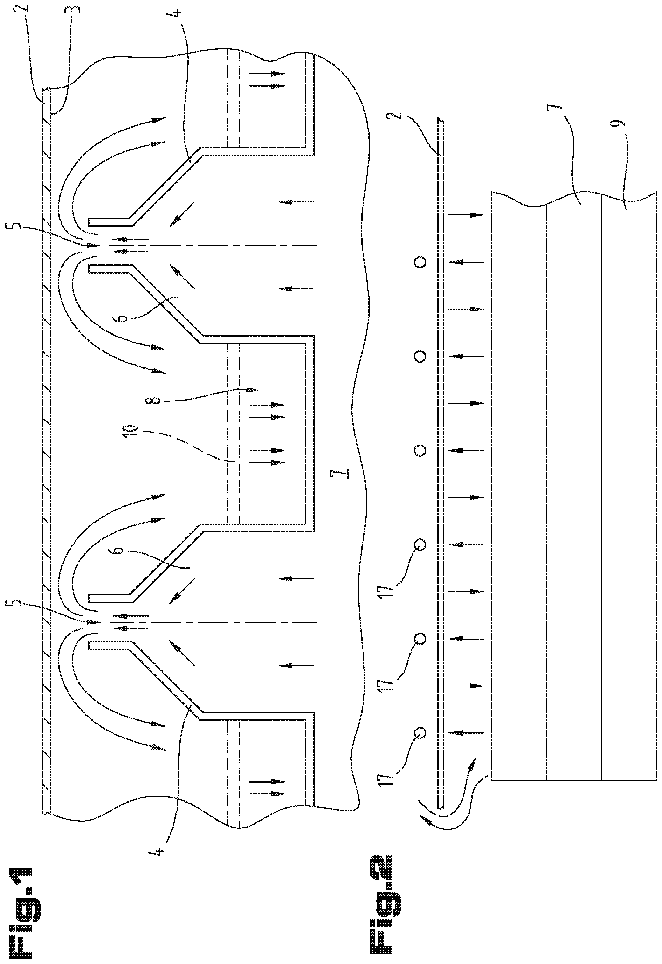

Gemäß Fig. 1 weist eine erfindungsgemäße Vorrichtung 1 ein Endlosband 2 auf, welches günstiger Weise eine geschlossene, bevorzugt gasdichte (luftdichte), Oberfläche hat und beispielsweise aus Metall, Prepreg-Materialien oder ähnlichen, geeigneten Materialen hergestellt sein kann.

An einer Unterseite 3 eines Obertrums des Endlosbandes 2 oder anders gesagt an einer, einer als Transportoberfläche für ein Medium, insbesondere für einen Film, dienenden äußeren Oberfläche gegenüberliegenden Innenseite des Obertrums sind Düsenkästen 4 mit Ausströmöffnungen 5 für ein gasförmiges Medium angeordnet. Das aus den Düsenkästen ausströmende gasförmige Medium ist von einer Unterseite 3 des Obertrums bzw. der Innenseite des Obertrums abgelenkt. In den Figuren ist die Strömungsrichtung des gasförmigen Mediums durch Pfeile angedeutet. Bei dem gasförmigen Medium handelt es sich bevorzugterweise um Luft, allerdings sei an dieser Stelle darauf hingewiesen, dass anstelle von Luft auch andere Gasgemische oder Gase zum Einsatz kommen können. So könnte anstelle von Luft auch ein Inertgas verwendet werden, um eine Schutzgasatmosphäre zu schaffen. Bei der Vorrichtung 1 handelt es sich bevorzugt um eine Vorrichtung zum Filmgießen, die einen Trocknungskasten aufweist, in welchem zumindest die Düsenkästen 4 sowie zumindest ein Abschnitt eines Obertrums des Endlosbandes 2 angeordnet sind. Obwohl in dem hier dargestellt Ausführungsbeispiel die Düsenkästen 4 nur an der Unterseite 3 des Endlosbandes 2 angeordnet sind, so ist es grundsätzlich möglich, auch an einer Oberseite des Endlosbandes 2 Düsenkästen 4 anzuordnen. An der Oberseite des Endlosbandes 2 können aber auch, wie in Fig. 2 dargestellt Heizelemente 17 zum Trocknen eines auf der Oberseite aufgebrachten Films vorgesehen sein.

Ein innerer Hohlraum 6 der Düsenkästen 4 ist mit einer Zuleitung 7 für das gasförmige Medium verbunden. Die Zuleitung 7 kann durch einen (kastenförmigen) Kanal gebildet werden, von welchem die inneren Hohlräume 6 aller Düsenkästen 4 abzweigen. Die inneren Hohlräume 6 der Düsenkästen 4 können in Richtung der Ausströmöffnungen 5 trichterförmig zulaufen. Jeder Düsenkasten 4 weist bevorzugt eine einzige Ausströmöffnung 5 auf, die in einer Querrichtung des Endlosbandes 2 betrachtet im Wesentlichen über die gesamte Breite b der Düsenkästen 4 verläuft.

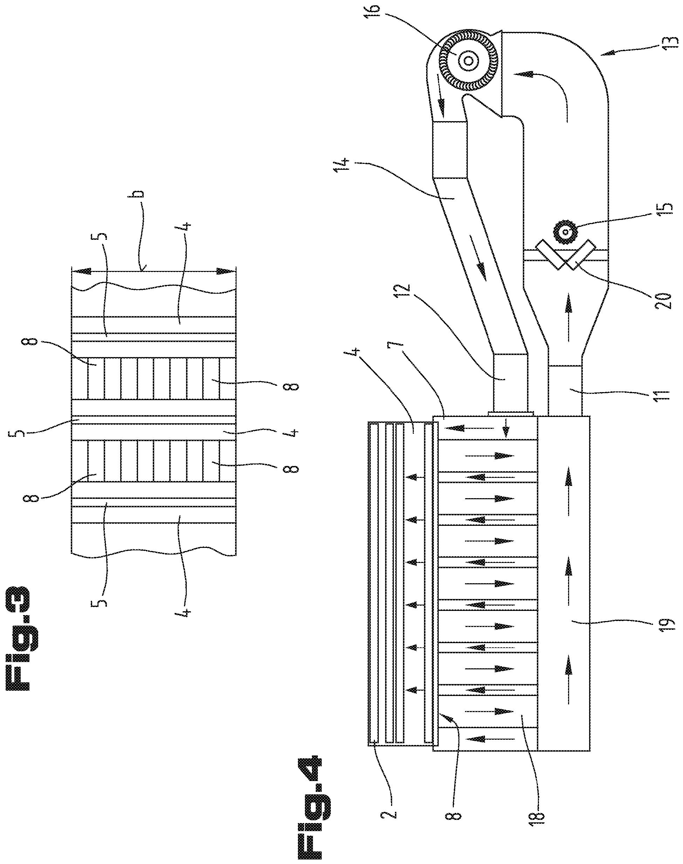

Zwischen zwei benachbarten Düsenkästen 4 sind Absaugöffnungen 8 angeordnet. Wie neben Fig. 1 auch aus Figur 3 erkennbar ist, sind zwischen einer Ausströmöffnung 5 und allen mit dieser unmittelbar benachbarten Ausströmöffnungen 5 jeweils mehrere Absaugöffnungen 8 angeordnet. Die Absaugöffnungen 8 können mit einem Filter 10 abgedeckt sein, der bevorzugt als Lochblech ausgeführt ist. Durch die soeben erwähnte Anordnung der Absaugöffnungen 8 und der Ausströmöffnungen 5 lassen sich vor allem in einem Anfangsbereich eines Trocknungstunnels eine Verwirbelung des verwendeten gasförmigen Mediums und ein unerwünschter Austausch zwischen einem über dem und unter dem Endlosband 2 befindlichen gasförmigen Medium (Luft) minimieren. In Fig. 2 ist dieser Anfangsbereich an dem linken Bildrand dargestellt.

Wie aus Fig. 1 und 3 erkennbar ist, kann eine in Längsrichtung des Endlosbandes 2 verlaufende Breite der Absaugöffnungen 8 im Wesentlichen dem Abstand zwischen zwei benachbarten Düsenkästen 4 entsprechen.

Weiters können die Absaugöffnungen 8 mit einer in Fig. 2 mit dem Bezugszeichen 9 gekennzeichneten Ableitung 9 für das gasförmige Medium verbunden sein. Wie aus Fig. 4 ersichtlich ist, kann die Ableitung 9 einen Kanal 19 aufweisen, in welchen rohrförmige Leitungen 18 münden. Diese rohrförmigen Leitungen 18 können einen polygonalen, rechteckigen, runden oder ovalen Querschnitt aufweisen. Allerdings hat sich ein rechteckiger Querschnitt in dem vorliegenden Zusammenhang als besonders vorteilhaft herausgestellt. An einem dem Endlosband 2 zugewandten Ende sind die Leitungen 18 offen ausgebildet, wobei die Absaugöffnungen 8 jeweils durch diese offenen Enden gebildet sind.

Wie es in Fig. 4 dargestellt ist, kann ein Ausströmbereich 11 der Ableitung 9 mit einem Einströmbereich 12 der Zuleitung 7 über eine Umlenkvorrichtung 13 zur Umkehrung einer Strömungsrichtung des gasförmigen Mediums verbunden sein. Durch die Verbindung der Ableitung 9 und der Zuleitung 7 kann ein geschlossener Kreislauf für das gasförmige Medium hergestellt werden.

Die Umlenkvorrichtung 13 kann einen Kanal 14 umfassen, der die Ableitung 9 bzw. den Kanal 19 der Ableitung 9 mit der Zuleitung 7 verbindet. Zur Erzeugung einer Strömung kann in dem Kanal 14 eine entsprechende Vorrichtung 16, beispielsweise ein Gebläse, angeordnet sein. Weiters kann sich in dem Kanal 14 ein Heizelement 15, z.B. ein Gasbrenner, befinden, um das gasförmige Medium in der Zuleitung 7 auf eine gewünschte Temperatur zu bringen. In Strömungsrichtung des gasförmigen Mediums betrachtet kann vor dem Heizelement 15 zumindest eine Abschirmung 20 angeordnet sein, durch welche das gasförmige Medium seitlich an dem Heizelement 15 vorbeigeleitet wird. Die Abschirmung 20 kann, wie es in Fig. 4 beispielhaft dargestellt ist, zwei Seitenwände (Bleche) aufweisen, die einen Winkel kleiner als 180° miteinander einschließen. Durch die Abschirmung 20 kann das Heizelement 15 vor dem strömenden Medium geschützt und im Fall der Verwendung eines Gasbrenners ein Auslöschen der Flamme verhindert werden.

Der Ordnung halber sei abschließend darauf hingewiesen, dass zum besseren Verständnis des Aufbaus der erfindungsgemäßen Vorrichtung diese bzw. deren Bestandteile teilweise unmaßstäblich und/oder vergrößert und/oder verkleinert dargestellt wurden.

### Bezugszeichenaufstellung

- 1: Vorrichtung
- 2: Endlosband
- 3: Unterseite
- 4: Düsenkasten
- 5: Ausströmöffnung
- 6: Hohlraum
- 7: Zuleitung
- 8: Absaugöffnung
- 9: Ableitung
- 10: Filter
- 11: Ausströmbereich
- 12: Einströmbereich
- 13: Umlenkvorrichtung
- 14: Kanal
- 15: Heizelement
- 16: Vorrichtung zur Erzeugung einer Strömung
- 17: Heizelement
- 18: Leitungen
- 19: Kanal
- 20: Abschirmung
- b: Breite

## Patentansprüche

1. Vorrichtung (1) mit zumindest einem Endlosband (2), wobei zumindest an einer Unterseite (3) eines Obertrums des zumindest einen Endlosbandes (2) Düsenkästen (4) mit je zumindest einer Ausströmöffnung (5) für ein gasförmiges Medium angeordnet sind, wobei das aus den Düsenkästen (4) ausströmende gasförmige Medium von der Unterseite (3) des Obertrums abgelenkt ist und ein innerer Hohlraum (6) der Düsenkästen (4) mit zumindest einer Zuleitung (7) für das gasförmige Medium verbunden ist, wobei zwischen zwei benachbarten Düsenkästen (4) zumindest eine mit zumindest einer Ableitung (9) für das gasförmige Medium verbundene Absaugöffnung (8) angeordnet ist, wobei zwischen der zumindest einen Ausströmöffnung (5) und allen mit dieser unmittelbar benachbarten Ausströmöffnungen (5) je zumindest eine der Absaugöffnungen (8) angeordnet ist, **dadurch gekennzeichnet, dass** die Absaugöffnungen (8) mit einem Filter (10) abgedeckt sind

2. Vorrichtung nach Anspruch 1, **dadurch gekennzeichnet, dass** der Filter (10) als Lochblech ausgeführt ist.

3. Vorrichtung nach einem der Ansprüche 1 bis 2, **dadurch gekennzeichnet, dass** eine in Längsrichtung des Endlosbandes (2) verlaufende Breite der Absaugöffnungen (8) dem Abstand zwischen zwei benachbarten Düsenkästen (4) entspricht.

4. Vorrichtung nach einem der Ansprüche 1 bis 3, **dadurch gekennzeichnet, dass** die Zuleitung (7) durch einen Zuleitungskanal gebildet wird, von welchem die inneren Hohlräume (6) aller Düsenkästen (4) abzweigen.

5. Vorrichtung nach einem der Ansprüche 1 bis 4, **dadurch gekennzeichnet, dass** die Ausströmöffnungen (5) in einer Querrichtung des Endlosbandes (2) betrachtet im Wesentlichen über die gesamte Breite (b) der Düsenkästen (4) verlaufen.

6. Vorrichtung nach einem der Ansprüche 1 bis 5, **dadurch gekennzeichnet, dass** die Ableitung (9) einen Ableitungskanal (19) aufweist, in welchen rohrförmige Leitungen (18) münden, die an einem dem Endlosband (2) zugewandten Ende jeweils offen ausgebildet sind, wobei die Absaugöffnungen (8) jeweils durch diese offenen Enden gebildet sind.

7. Vorrichtung nach einem der Ansprüche 1 bis 6, **dadurch gekennzeichnet, dass** ein Ausströmbereich (11) der Ableitung (9) mit einem Einströmbereich (12) der Zuleitung (7) über eine Umlenkvorrichtung (13) zur Umkehrung einer Strömungsrichtung des gasförmigen Mediums verbunden ist.

8. Vorrichtung nach Anspruch 7, **dadurch gekennzeichnet, dass** die Umlenkvorrichtung (13) einen Kanal (14) umfasst, der die Ableitung (9) mit der Zuleitung (7) verbindet, wobei in dem Kanal (14) zumindest ein Heizelement (15), insbesondere ein Gasbrenner, angeordnet ist, wobei in einer Strömungsrichtung des gasförmigen Mediums betrachtet vor dem Heizelement (15) zumindest eine Abschirmung (20) angeordnet ist, durch welche das gasförmige Medium seitlich an dem Heizelement (15) vorbeigeleitet ist.

9. Vorrichtung nach Anspruch 8, **dadurch gekennzeichnet, dass** in dem Kanal (14) eine Vorrichtung (16) zur Erzeugung einer Strömung in dem gasförmigen Medium, insbesondere ein Gebläse, angeordnet ist.

## Claims

1. A device (1) comprising at least one endless belt (2), wherein nozzle chambers (4), each having at least one outflow port (5) for a gaseous medium, are arranged at least on a lower face (3) of an upper strand of the at least one endless belt (2), wherein the gaseous medium flowing out of the nozzle chambers (4) is deflected from the lower face (3) of the upper strand, and an internal cavity (6) of the nozzle chambers (4) is connected to at least one supply line (7) for the gaseous medium, wherein at least one suction port (8) which is connected to at least one discharge line (9) for the gaseous medium is arranged between two adjacent nozzle chambers (4), wherein at least one of the suction ports (8) is arranged between the at least one outflow port (5) and all of the outflow ports (5) immediately adjacent thereto, **characterised in that** the suction ports (8) are covered by a filter (10).

2. The device according to claim 1, **characterised in that** the filter (10) is designed as a perforated metal sheet.

3. The device according to one of claims 1 to 2, **characterised in that** a width of the suction ports (8) extending in the longitudinal direction of the endless belt (2) corresponds to the spacing between two adjacent nozzle chambers (4).

4. The device according to one of claims 1 to 3, **characterised in that** the supply line (7) is formed by a supply line channel, the internal cavities (6) of all of the nozzle chambers (4) branching off from said supply line channel.

5. The device according to one of claims 1 to 4, **characterised in that**, viewed in a transverse direction of the endless belt (2), the outflow ports (5) extend substantially over the entire width (b) of the nozzle chambers (4).

6. The device according to one of claims 1 to 5, **characterised in that** the discharge line (9) has a discharge line channel (19), tubular lines (18) discharging therein, said tubular lines being configured in each case to be open at an end facing the endless belt (2), wherein the suction ports (8) are formed in each case by these open ends.

7. The device according to one of claims 1 to 6, **characterised in that** an outflow region (11) of the discharge line (9) is connected to an inflow region (12) of the supply line (7) via a deflection device (13) for reversing a direction of flow of the gaseous medium.

8. The device according to claim 7, **characterised in that** the deflection device (13) comprises a channel (14) which connects the discharge line (9) to the supply line (7), wherein at least one heating element (15), in particular a gas burner, is arranged in the channel (14), wherein, viewed in a direction of flow of the gaseous medium, at least one shield (20) is arranged upstream of the heating element (15), the gaseous medium being conducted by said shield past the heating element (15) at the sides thereof.

9. The device according to claim 8, **characterised in that** a device (16) for producing a flow in the gaseous medium, in particular a fan, is arranged in the channel (14).

## Revendications

1. Dispositif (1), avec au moins une bande sans fin (2), des caissons à buses (4) avec chacun au moins un orifice d'éjection (5) pour un milieu gazeux étant disposés au moins sur une face inférieure (3) d'un brin supérieur de la bande sans fin (2) au moins au nombre de un, le milieu gazeux éjecté des caissons à buses (4) étant dévié de la face inférieure (3) du brin supérieur, et une cavité (6) intérieure des caissons à buses (4) étant raccordée à au moins une conduite d'amenée (7) du milieu gazeux, au moins un orifice d'aspiration (8) raccordé à au moins une conduite d'évacuation (9) du milieu gazeux étant disposé entre deux caissons à buses (4) voisins, respectivement au moins un des orifices d'aspiration (8) étant disposé entre l'orifice d'éjection (5) au moins au nombre de un et tous les orifices d'éjection (5) immédiatement voisins de celui-ci, **caractérisé en ce que** les orifices d'aspiration (8) sont recouverts d'un filtre (10).

2. Dispositif selon la revendication 1, **caractérisé en ce que** le filtre (10) est réalisé en tant que tôle perforée.

3. Dispositif selon l'une des revendications 1 à 2, **caractérisé en ce qu'**une largeur des orifices d'aspiration (8) s'étendant dans la direction longitudinale de la bande sans fin (2) correspond à la distance entre deux caissons à buses (4) voisins.

4. Dispositif selon l'une des revendications 1 à 3, **caractérisé en ce que** la conduite d'amenée (7) est formée par un canal d'amenée dont bifurquent les cavités (6) intérieures de tous les caissons à buses (4).

5. Dispositif selon l'une des revendications 1 à 4, **caractérisé en ce que** les orifices d'éjection (5), vus dans une direction transversale de la bande sans fin (2), s'étendent essentiellement sur toute la largeur (b) des caissons à buses (4).

6. Dispositif selon l'une des revendications 1 à 5, **caractérisé en ce que** la conduite d'évacuation (9) présente un canal d'évacuation (19) dans lequel débouchent des conduites (18) tubulaires qui sont constituées respectivement de façon ouverte sur un côté tourné vers la bande sans fin (2), les orifices d'aspiration (8) étant formés respectivement par ces extrémités ouvertes.

7. Dispositif selon l'une des revendications 1 à 6, **caractérisé en ce qu'**une zone d'éjection (11) de la conduite d'évacuation (9) est raccordée à une zone d'afflux (12) de la conduite d'amenée (7) par le biais d'un dispositif de déviation (13) destiné à inverser une direction d'écoulement du milieu gazeux.

8. Dispositif selon la revendication 7, **caractérisé en ce que** le dispositif de déviation (13) comprend un canal (14) qui raccorde la conduite d'évacuation (9) à la conduite d'amenée (7), au moins un élément chauffant (15), en particulier un brûleur à gaz, étant disposé dans le canal (14), au moins un blindage (20) étant disposé avant l'élément chauffant (15), vu dans une direction d'écoulement du milieu gazeux, au moyen duquel le milieu gazeux est conduit de façon à passer sur le côté de l'élément d'entraînement (15).

9. Dispositif selon la revendication 8, **caractérisé en ce que**, dans le canal (14), il est disposé un dispositif (16) destiné à produire un écoulement dans le milieu gazeux, en particulier un ventilateur.
